(19) Europäisches Patentamt
European Patent Office
Office européen des brevets

(11) **EP 2 943 985 B1**

(12) **EUROPEAN PATENT SPECIFICATION**

(45) Date of publication and mention
of the grant of the patent:
**07.07.2021  Bulletin 2021/27**

(21) Application number: **13824031.2**

(22) Date of filing: **17.12.2013**

(51) Int Cl.:
**H01L 33/00** *(2010.01)*          **H01L 33/20** *(2010.01)*
**H01L 33/24** *(2010.01)*          **H01L 33/30** *(2010.01)*

(86) International application number:
**PCT/IB2013/061038**

(87) International publication number:
**WO 2014/108777 (17.07.2014 Gazette 2014/29)**

(54) **SHAPED LED FOR ENHANCED LIGHT EXTRACTION EFFICIENCY**

GEFORMTE LED FÜR EFFIZIENTERE LICHTAUSKOPPLUNG

DEL DE FORME PARTICULIÈRE POUR RENDEMENT AMÉLIORÉ D'EXTRACTION DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.01.2013  US 201361749941 P**

(43) Date of publication of application:
**18.11.2015  Bulletin 2015/47**

(73) Proprietor: **Lumileds LLC**
**San Jose, CA 95131 (US)**

(72) Inventors:
• **TURCOTTE, Stéphane**
**NL-5656 AE Eindhoven (NL)**

• **WU, Songnan**
**NL-5656 AE Eindhoven (NL)**

(74) Representative: **ter Heegde, Paul Gerard Michel**
**Lumileds Germany GmbH**
**Philipsstraße 8**
**52068 Aachen (DE)**

(56) References cited:
**WO-A1-2006/068297          WO-A2-99/31738
WO-A2-2006/030678          JP-A- H0 982 587
US-A1- 2004 266 043          US-A1- 2009 032 799
US-A1- 2010 308 300**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

FIELD OF THE INVENTION

This invention relates to the field of light emitting devices, and in particular to light emitting devices that are shaped to increase the efficiency of extraction of light from the surfaces of the device.

BACKGROUND OF THE INVENTION

The increased use of solid-state light emitting devices for lighting applications has created a highly competitive market in which cost and lighting efficiency are predominant factors. Techniques that improve the light output efficiency of the devices and/or the lighting assembly are desirable to distinguish the devices from the competition and increase market share.

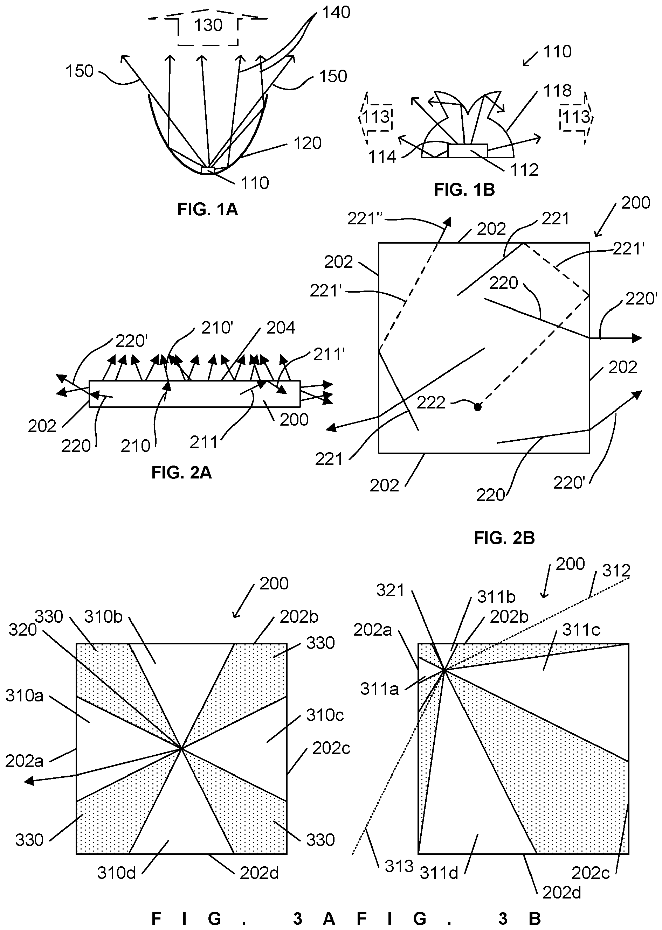

A common technique for improving light output efficiency is to enclose the light emitting device 110 in a reflective structure (or: reflector, or: reflective surface) 120, typically parabolic, that directs the emitted light in a desired direction, as illustrated in FIG. 1A. Such a reflector 120 may be used, for example, to direct the light from a flash element in a camera or other portable device, such as a cell phone. To maximize the advantages provided by such a reflector 120, most of the emitted light should be directed toward the reflective surface, so that it is redirected toward the desired direction 130, as illustrated by first light rays 140. Light that does not strike the reflective surface 120 may travel in an unwanted direction, as illustrated by the second light rays 150. Accordingly, conventional light emitting devices 110 that use a parabolic reflector are commonly configured to emit light in a lateral direction 113, relative to the "upper" light emitting surface (or: upper surface) 114 of the light emitting element 112, toward the reflective surface 120. A concentric side-reflecting lens 118, such as illustrated in FIG. 1B, is commonly used to provide redirection of the light emitted from the upper surface 114 of the light emitting element 112.

In like manner, semiconductor light emitting elements are commonly used as backlights for illuminating display screens. Commonly, side-emitting structures are situated adjacent to or within a light guide that is situated below the display panel. The side-emitting light illuminates the light guide, which subsequently illuminates the display panel. In US 2004/266043 A1, an n-type GaN layer is grown onto a sapphire substrate and a hexagonal etching mask is formed onto the n-type GaN layer as provided. The n-type GaN layer is etched to a predetermined depth by using the etching mask by the RIE method. A hexagonal prism portion whose upper surface is a C plane is formed. After the etching mask is removed, an active layer and a p-type GaN layer are sequentially grown onto the whole surface of the substrate so as to cover the hexagonal prism portion, thereby forming a light emitting device structure. After that, a p-side electrode is formed onto the p-type GaN layer of the hexagonal prism portion and an n-side electrode is formed onto the n-type GaN layer.

US 2009/032799 A1 discloses a light emitting device including a substrate and a light emission layer. The substrate has a first and second surface. The light emission layer is disposed over the second surface. The light emission layer has planar light emission surfaces which are not parallel to the first surface of the substrate and which are not planar with or orthogonal to an adjacent light emission surface. US 2010/308300 A1 describes an integrated circuit device, which can be a light emission device such as a light emitting diode (LED), comprising a substrate, a plurality of device layers formed on a first surface of the substrate, including a first device layer and a second device layer, a first electrode formed on the first device layer, and a second electrode formed on a second surface of the substrate which is parallel and opposite to the first surface of the substrate. A plurality of substantially identical such devices can be formed on a semiconductor wafer, where one or both of the first and second electrodes are shared by the plurality of devices prior to dicing the wafer.

SUMMARY OF THE INVENTION

It would be advantageous to increase the light output efficiency of a light emitting device. It would also be advantageous to improve the uniformity of the light output and/or to improve the reliability of the light emitting device.

A light emitting device according to the invention is defined by claim 1 and a method of manufacturing the light emitting device according to the invention is defined by claim 9. Preferred embodiments of the invention are defined by the dependent claims. To better address one or more of the above concerns, in an embodiment of this invention, the shape of a light emitting element of a light emitting device is designed to increase the amount of light that escapes from the surfaces of the light emitting element. The indices of refraction of the light emitting element and the surrounding environment define an escape zone through which light may escape through a surface of the light emitting element. Light traveling outside the escape zone is totally internally reflected (TIR) at the surface. By increasing the number of surfaces on the light emitting element, the number of escape zones may be increased, with a corresponding increase in the likelihood of light escaping the surface. A polygonal surface with more than four sides also provides for more uniform current injection, and reduced mechanical stress, compared to a rectangular surface.

The light emitting element of the light emitting device includes a side-view profile that includes a polygon with more than four sides, forming a light extraction region that includes a plurality of planar light extraction surfaces, at least one light extraction surface being non-orthogonal to, and non-planar with, an adjacent light extraction surface, wherein the polygon is a regular polygon. In preferred embodiments, the light-emitting element further comprises a top-view profile that includes another polygon with more than four sides, the light emitting element is a polyhedron of at least seven faces, the light emitting element has a shape that corresponds to a combination of multiple polygons or polyhedrons, or the light emitting element further comprises one or more reflective surfaces, which will redirect light toward a desired direction. One or more of the surfaces (planes) outlined in the profiles may be used for electrical contact or current injection purposes. The light emitting element is situated on a substrate, and the top-view profile of the substrate may correspond to the top-view profile of the light emitting element, or it may differ. The substrate may include features that facilitate the creation of a light emitting element with a side-view profile that includes the polygon with more than four sides.

BRIEF DESCRIPTION OF THE DRAWINGS

The invention is explained in further detail, and by way of example, with reference to the accompanying drawings wherein:

FIG. 1A illustrates an example prior art lighting device with parabolic reflector, and
FIG. 1B illustrates an example prior art light emitting device for use with such a reflector.
FIGs. 2A and 2B illustrate side and top views of a rectangular light emitting element not falling under the claimed invention.
FIGs. 3A and 3B illustrate example escape zones of a rectangular light emitting element not falling under the claimed invention.
FIGs. 4A and 4B illustrate example escape zones of a hexagonal light emitting element not falling under the claimed invention.
FIGs. 5A and 5B illustrate example escape zones of an octagonal light emitting element not falling under the claimed invention.
FIGs. 6A-6D illustrate example alternative shapes for non-rectangular light emitting elements not falling under the claimed invention.
FIGs. 7A-7E illustrate example wafers comprising non-rectangular light emitting elements not falling under the claimed invention.
FIGs. 8A-8B illustrate example light emitting elements with non-rectangular cross-section profiles not falling under the claimed invention.

Throughout the drawings, the same reference numerals indicate similar or corresponding features or functions. The drawings are included for illustrative purposes and are not intended to limit the scope of the invention.

DETAILED DESCRIPTION

In the following description, for purposes of explanation rather than limitation, specific details are set forth such as the particular architecture, interfaces, techniques, etc., in order to provide a thorough understanding of the concepts of the invention. However, it will be apparent to those skilled in the art that the present invention may be practiced in other embodiments, which depart from these specific details. In like manner, the text of this description is directed to the example embodiments as illustrated in the Figures, and is not intended to limit the claimed invention. For purposes of simplicity and clarity, detailed descriptions of well-known devices, circuits, and methods are omitted so as not to obscure the description of the present invention with unnecessary detail.

In example embodiments, the shape of a light emitting element of a light emitting device is controlled to reduce the likelihood that light emitted from points within the device will strike a surface at greater than the critical angle, relative to a normal to the surface. The critical angle is determined by the indices of refraction n1 and n2 of the material on either side of the surface, and is equal to:

$$\arcsin(n2/n1), \qquad\qquad \text{(Equation 1)}$$

for light traveling from the medium having an index of refraction n1 into a medium having an index of refraction of n2. Light that strikes the surface at greater than the critical angle will be totally internally reflected, and will not escape through the surface. The term "escape zone" is used to define the range of angles within which light will escape through the surface.

In the ideal case, all of the light from a point source at the center of a sphere that strikes the surface of the sphere will escape through the surface, because the light that is emitted from the center of the sphere will strike the surface of the sphere at an angle that is normal to the surface. Point sources, however are not currently feasible, and given that the light source will consume some space within the sphere, not all of the light will be emitted from the exact center of the sphere.

Light that is generated from points that are off center may strike the spherical surface at angles that are not normal to the surface, but the likelihood of the light striking the spherical surface at angles greater than the critical angle is substantially less than the likelihood of light striking a planar surface at angles greater than the critical angle. This is due to the fact that each point on the spherical surface has an escape zone relative to a tangent to the surface; and, relative to each point within the sphere, these escape zones will overlap.

Similarly, the escape zones from the sides of a cylindrical surface will also overlap, providing for a high light extraction efficiency for light emitted in the direction of the curved cylindrical surface.

Despite the efficiencies that may be gained by the use of spherical or cylindrical surfaces surrounding the light source, the costs associated with forming light emitting elements in the shape of spheres or cylinders precludes their use for commercial production of light emitting elements. The forming of such shapes from a wafer of multiple light emitting elements would generally require milling, laser-cutting, or mechanical sawing of each light emitting element, with significant waste of the materials between each light emitting element produced by such processes.

Although spherical or cylindrical light emitting elements may not currently be feasible, the principles of this paradigm can be applied to use other shapes that improve the likelihood of light escaping directly from points within a light emitting region. In example embodiments, for example, multi-sided shapes are used to increase the number of escape zones, thereby increasing the likelihood that the light generated from points within the light emitting element will be within an escape zone. Preferably, the shapes are formed using multiple planar surfaces, thereby avoiding the need to shape curved surfaces; and, if the planar surfaces of adjacent light emitting elements are arranged on the wafer in alignment, a single slicing operation may be used to provide these aligned surfaces. Additionally, if the planar surfaces abut each other, less material is wasted in the formation of the individualized ('singulated') light emitting elements. For example, a regular hexagonal tessellation provides a pattern of hexagons that is devoid of space between the hexagons. Although such a design does not provide for a simple cutting/slicing pattern, with the advances in techniques such as laser slicing, the cost of effecting hexagonal slices may be offset by the elimination of waste that needs to be allowed for and disposed of.

FIGs. 2A and 2B illustrate side and top views of a rectangular light emitting element (or: light emitting element) 200 not falling under the claimed invention. As illustrated in FIG. 2A, the majority of light from the light emitting element 200 is emitted from the upper surface 204 of the light emitting element. First light 210 is generated within the interior of the light emitting element 200, and strikes the upper surface 204. If the first light 210 is within the escape zone of the light emitting element 200 relative to the upper surface 204, it is able to escape through the surface as first emitted light 210'; if the second light 211 is not within the escape zone, the second light 211 will be totally internally reflected (TIR) as first reflected light 211'.

In addition to the light 210, 211 that strikes the upper surface 204, some light 220, 221 will strike the sides 202, or edges, of the light emitting element 200, as further illustrated in FIG. 2B. If the third light 220 is within the escape zone relative to the sides 202, it will be emitted as second emitted light 220'; if the fourth light 221 is not within the escape zone, it will be totally internally reflected as second reflected light 221'. The light 211, 221 that is reflected from the upper surface 204 or sides 202 may eventually strike another surface within the escape zone of that surface and will be emitted from that surface, as illustrated as third emitted light 221" in FIG. 2B. Some of the reflected light, however, may be absorbed within the light emitting element 200 before it is able to escape; it may also continue to be internally reflected, further increasing the likelihood that this reflected light will be absorbed within the light emitting element 200 and converted to heat energy, as illustrated by the terminated reflected light 222 in FIG. 2B.

As noted above, the likelihood of light being emitted through a surface is dependent upon the escape zone associated with the surface. This escape zone is determined by the indices of refraction on either side of the surface. If the light strikes the surface within the 'critical angle', the light will travel through the surface; if not, it will be totally internally reflected. Relative to the surface, a projection of the extent of the critical angle about a normal to the surface from a point within the surface defines a zone for light generated from that point escaping through the surface.

The index of refraction of an AlInGaP active region is about 3.5, and the index of refraction of a silicone encapsulant is about 1.4. Accordingly, using Equation 1, above, the critical angle for light generated within such an active region escaping through a surface and into the silicone encapsulant is about 23.6 degrees. Thus, the escape zone for light generated from a point within the active region is a cone whose cross-section subtends the angle 2*23.6 degrees (+/- 23.6 degrees relative to a normal to the surface), which amounts to a solid angle of about 0.53 steradians. The escape zone for light into air from AlInGaP is about +/- 17.5 degrees, which amounts to about 0.3 steradians.

Although escape zones are defined by solid angles, this disclosure is presented using a two dimensional model, for ease of presentation and understanding. One of skill in the art will recognize that the conclusions drawn from the following analysis of two dimensional optical models are the same as the ones that would be drawn from a more complex analysis using a three dimensional model.

In the subsequent presentation, for ease of understanding, the example critical angle is about 24 degrees, corresponding to the example combination of an AlInGaP active region and a silicone encapsulant. One of skill in the art will recognize that the principles of this invention are applicable to any particular combination of material and/or any particular value of the critical angle.

FIG. 3A illustrates a top view of example first through fourth escape zones 310a, 310b, 310c, and 310d (collectively, escape zones 310) from a center point 320 at the center of the light emitting element 200 not falling under the claimed invention relative to each of the first through fourth sides 202a, 202b, 202c, and 202d (collectively, sides 202), respectively, using the above example of a critical angle of about 24 degrees. Any light that is emitted from the center point 320 at an angle within the escape zones 310 will escape through the sides 202; light emitted from the center point 320 at angles outside the escape zones 310 will be totally internally reflected. The regions outside the illustrated escape zones 310 are shaded in FIG. 3A.

Light that may be generated from the center point 320 may be emitted at any angle. Using a two dimensional model, the emitted light may be emitted over a range of 0-360 degrees toward the sides 202. Of this entire 360 degree range, the light will either be within the escape zones 310, or a TIR region 330. Assuming a critical angle of 24 degrees, the escape zones amount to 192 degrees (4*48 degrees), or just over half (192/360) the range of emitted light. Thus, almost half (168/360) of the light emitted from the center point 320 of the active region toward the sides 202 will be internally reflected when it strikes the sides 202 of the light emitting element 200. As noted above, internally reflected light travels further through the active region before it may escape, thereby increasing the likelihood that it will be absorbed before being able to escape.

The escape zones for any particular point in the active region will depend upon the relationship between that particular point and each of the sides 202 of the light emitting element 200. The amount of light that is able to escape from points away from the center point 320 will generally be even less than this estimated 53% (192/360) from the center point 320 of the light emitting element 200, as illustrated in FIG. 3B.

FIG. 3B illustrates example first through fourth escape zones 311a, 311b, 311c, and 311d (collectively, escape zones 311) of an example point 321 within the light emitting element 200 not falling under the claimed invention relative to the first through fourth sides 202a, 202b, 202c, and 202d. As illustrated in this example two dimensional model, first and second escape zones 311a and 311b will allow light within the full range of 48 degrees each to escape through the first and second sides 202a and 202b. However, because the example point 321 is offset significantly from center, the span of the third and fourth escape zones 311c and 311d is truncated, because the full 48 degree span, as illustrated by the first and second dotted lines 312 and 313 extends beyond the third and fourth sides 202c and 202d. Thus, the third and fourth escape zones 311c and 311d provide less than the full escape range of 48 degrees. Accordingly, the amount of light generated at example point 321 that will escape through the third and fourth sides 202c and 202d is reduced, and the amount of light that will be totally internally reflected at these third and fourth sides 202c and 202d is increased. In this example, the escape zones 311 amount to about 150 degrees, and the proportion of light from example point 321 toward the first to fourth sides 202a-202d that is directly emitted is reduced to about 42% (150/360).

The total proportion of light that can be expected to directly exit the sides 202 from the light emitting element 200 will be the integral of the proportion of light that can be expected to exit the sides 202 from each point within the light emitting element 200. As the example of FIG. 3B illustrates, however, this integral will generally be less than the proportion of light that can be expected to exit the sides 202 from a point in the center of the light emitting element. Thus the proportion determined based on light emitted from the center of the light emitting element can generally be considered a maximum proportion of light that can be expected to directly exit the sides 202, without being totally internally reflected.

The light extraction efficiency (the amount of light that is emitted v. the amount of light generated) is commonly increased by increasing the size of the escape zones, typically by reducing the differences in indices of refraction. However, the cost and complexity of refractive index matching limits the amount of improvement that is feasible and/or practical.

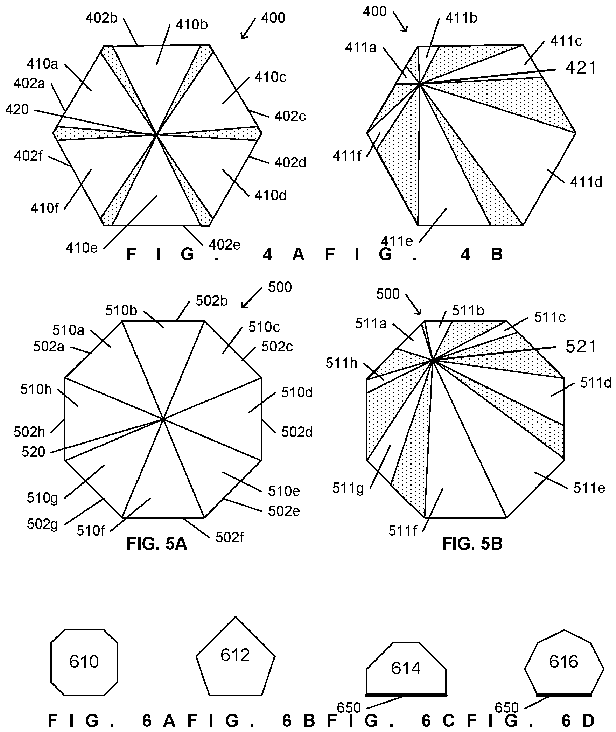

FIGs. 4A and 4B illustrate example escape zones in a hexagonal light emitting element (or: light emitting element) 400 not falling under the claimed invention. As in the prior example of a rectangular light emitting element having an AlInGaP active region surrounded by a silicone encapsulant, the width of each example escape zone is about 48 degrees.

The first to sixth escape zones 410a-f of FIG. 4A are illustrated for light that is generated at the center 420 of the light emitting element 400. Because there are six escape zones, the proportion of light from the center 420 toward the first to sixth sides 402a-f that will directly escape through the first to sixth sides 402a-f of the hexagonal light emitting element 400 is about 80% (6*48/360), as compared to 53% (4*48/360) in the rectangular light emitting element 200 of FIG. 3A.

The first to sixth escape zones 411a-f of FIG. 4B are illustrated for light that is generated at a point 421 that is substantially distant from the center 420. Although the proportion of the generated light that will be totally internally reflected (shaded TIR regions) from the first to sixth sides 402a-f is greater than the example of FIG. 4A, it can be shown that the angles encompassed by these TIR regions amount to less than the angles encompassed by the TIR regions of FIG. 3B. In this example, the escape zones amount to about 180 degrees, as compared to about 150 degrees in FIG. 3B. [Not directly. In the example of FIG. 3B, the first and second escape zones 311a and 311b amount to very little of the edge. However, assuming light is emitting in a random direction, these zones will amount to more than half the light that is able to directly escape the light emitting element 200.]

As the shape more closely approximates a circular perimeter, the light extraction efficiency will further increase. FIGs. 5A and 5B illustrate example escape zones in an octagonal light emitting element (or: light emitting element) 500 not falling under the claimed invention. FIG. 5A illustrates the first to eighth escape zones 510a-h from the center 520 of the light emitting element 500 relative to each first to eighth side 502a-h, using the same example AlInGaP active region surrounded by a silicone encapsulant. Because each escape zones encompasses 48 degrees, and each first to eighth side 502a-h extends 45 degrees relative to the center 520, there is no direction from the center 520 toward the first to eighth sides 502a-h that is not within a first to eighth escape zone 5 10a-h. Accordingly, all (8*45/360 = 100%) of the light that is generated at the center of the octagonal light emitting element 500 toward the first to eighth sides 502a-h will exit the light emitting element 500, as compared to 53% (4*48/360) in the rectangular light emitting element 200 of FIG. 3A, and 80% (6*48/360) in the hexagonal light emitting element 400 of FIG. 4A.

FIG. 5B illustrates the first to eighth escape zones 511a-h from an off-center point 521 relative to the first to eighth sides 502a-h. As can be seen, the first to eighth escape zones 511a-h of the octagonal light emitting element 500 encompass a larger area than the first to sixth escape zones 411a-f of the hexagonal light emitting element 400 of FIG. 4B, and the first to fourth escape zones 311a-d of the rectangular light emitting element 200 of FIG. 3B.

Further improvements in light extraction efficiency may be achieved by further increasing the number of sides of the light emitting element, and correspondingly, the number of escape zones.

As the shape of the light emitting element approaches a circular shape, other advantages will also be realized, compared to the rectangular shape.

Semiconductor light emitting elements rely on current injection through the semiconductor layers and into the light emitting region between these layers. To provide current injection across the entire area of the semiconductor layers and light emitting region, the contacts that provide current to the semiconductor layers are shaped to cover as much of the surface area of the semiconductor layers as possible.

A rectangular light emitting element will typically have rectangular contacts that connect to each of an N-type and a P-type semiconductor layer. However, a rectangular contact will exhibit non-uniform current injection and current crowding, which will cause a non-uniform light output pattern. Some of these adverse effects, such as current crowding, are more likely to occur at the corners of the contacts, and can become more pronounced as the angle formed at the corner of the contact gets narrower. Therefore, the corners of a rectangular die will be more susceptible to non-uniform current spreading and other electrical edge effects.

In a rectangle, the corners have an angle of 90 degrees. In a hexagon, the angle increases to 120 degrees, and in an octagon, the angle increases to 135 degrees. Accordingly, the adverse effects, such as non-uniform current injection, current crowding, and others will be substantially reduced as the number of sides of the light emitting element increases.

Additionally, a rectangular structure exhibits concentrated mechanical stress at the orthogonal corners, and mechanical failures are more likely to be produced at these corners. The corners on structures with more sides than a rectangular structure, on the other hand, will exhibit less mechanical stress, because the corners are blunter. By increasing the number of sides along the perimeter of a light emitting element, the interior angles are increased, reducing the mechanical stress that occurs at the vertices of the light emitting element.

Due to the significant increase in side-emission efficiency that can be expected, the use of many-sided polygons may allow for light emitting elements that emit solely, or primarily, through the sides. Such embodiments may allow, for example, full blanket sheets of contact deposition for the top and bottom contacts to the light emitting element, and allow for these contacts to be opaque, thereby extending the range of materials that may be used for the contacts, including reflective materials.

One of skill in the art will recognize that any of a variety of shapes may be employed to achieve a desired light output pattern from the sides of a light emitting element, and that these shapes need not be regular polygons, non even symmetric. FIGs. 6A-6D illustrate other first through fourth example shapes 610, 612, 614, and 616 not falling under the claimed invention. In FIGs. 6C and 6D, a reflective surface 650 is formed on one of the sides of the light emitting elements to redirect light that strikes that surface, regardless of the angle of incidence, so as to produce an asymmetric distribution of light from the sides of the light emitting elements. Such an asymmetric distribution may be advantageously used, for example, along the edges of a waveguide that provides backlighting to a display.

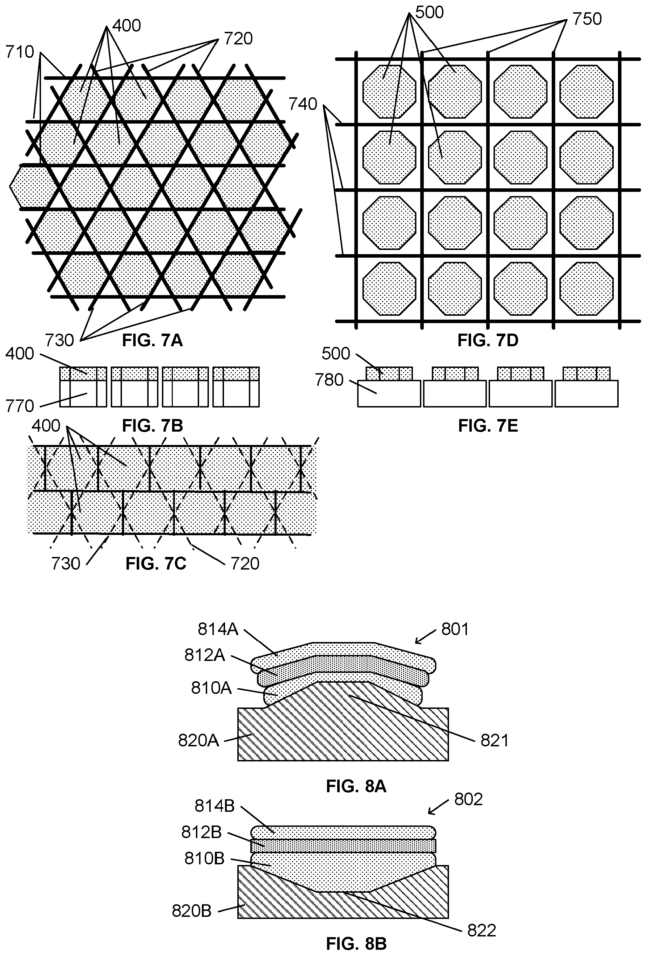

FIG. 7A illustrates an example wafer comprising a plurality of hexagonal light emitting elements 400 not falling under the claimed invention. The first through third lines 710, 720, and 730 illustrate cuts that may be made through the wafer to singulate the individual hexagonal light emitting elements 400, as illustrated in FIG. 7B, which illustrates a side view of the singulated light emitting elements 400 on a substrate 770. As illustrated, the resultant die not falling under the claimed invention, comprising the substrate 770 and the light emitting element 400 will be hexagonal, and the residual waste is minimal. In the example of FIG. 7A, the light emitting elements 400 may be created as rectangular light emitting elements that are shaped to be hexagonal by the slicing along the second and third lines 720 and 730, as illustrated in FIG. 7C.

Alternatively, if the light emitting elements are formed on the wafer as individual elements with a polygon perimeter, the wafer may be cut in the orthogonal manner to produce rectangular portions of the substrate upon which the non-rectangular light emitting elements are situated, as illustrated in FIGs. 7D and 7E.

FIG. 7D illustrates a top view of a wafer wherein individual octagonal light emitting elements 500 not falling under the claimed invention are formed. Such forming may be accomplished using conventional photolithographic or other techniques common in the art of semiconductor fabrication, with a removable material situated between the light emitting elements 500. Other forming techniques, such as DRIE (Deep Reactive-Ion Etching), FIB (Focused Ion Beam) etching, and ICP (Inductive Coupled Plasma) etching may also be used. After forming the individual elements, the wafer may be sliced along the fourth and fifth lines 740 and 750, to singulate the individual light emitting elements 500.

FIG. 7E illustrates a cross section of the individual light emitting elements 500 after such slicing and removal of the material between the light emitting elements 500, if any. As illustrated, the octagonal light emitting elements 500 are situated upon the wafer substrate 780, which is shaped as a rectangularly shaped die not falling under the claimed invention. Situating the light emitting element on a rectangular die may facilitate the use of conventional picking and placement techniques for subsequent processing of the die.

Other techniques for forming and singulating non-rectangular light emitting elements on conventional or unconventional substrates will be evident to one of skill in the art in view of this disclosure. For example, the light emitting elements on the wafer (growth substrate) of either FIG. 7A or 7D may be attached to another substrate in a flip-chip embodiment, and the growth substrate may be subsequently removed. In this example, the shape of the die will be determined by how the second substrate is sliced, regardless of the placement of the light emitting elements on the growth substrate.

Using the aforementioned paradigm of an ideal spherical emitter, one of skill in the art will recognize that the principles of this invention are not limited to shaping the perimeter of a light emitting element.

Light emitting elements may have a rectangular cross-section (or side-view profile), as well as a rectangular perimeter (or top-view profile). Accordingly, changing the shape of either of these rectangular profiles may enhance the light output efficiency from the surfaces outlined by these profiles. In particular, changing the side-view profile of the light emitting element by increasing the number of surfaces 'above' or 'below' the light emitting layer may enhance the light output efficiency for light escaping from these surfaces.

FIGs. 8A-8B illustrate example cross sections of non-planar first and second light emitting elements (or: first and second light emitting elements) 801 and 802 not falling under the claimed invention. In these examples, the first and second light emitting elements 801 and 802 are formed upon first and second features 821 and 822 that are formed on or in the first and second substrates 820A and 820B. Each of the first and second light emitting elements 801 and 802 includes a first and second active layer 812A and 812B sandwiched between a first N-type semiconductor layer 810A and a first P-type semiconductor layer 814A and a second N-type semiconductor layer 810B and a second P-type semiconductor layer 814B, respectively. Because of the features 821, 822, the layers 810A, 810B, 812A, 812B, 814A, 814B of the light emitting elements 801, 802 are non-planar. In FIG. 8A, the light emitting element 801 is convex, with the center region extending above the outer regions. The non-planar shape of the light emitting element will enhance the light extraction efficiency for light exiting the upper layer of the light emitting element by reducing the likelihood of total internal reflection at the outer surface of the upper layer.

In FIG. 8B, the light emitting element 802 is concave, with the center region extending below the outer regions. This configuration may be used in a 'flip-chip' embodiment, wherein light is intended to be emitted through the lower layer of the light emitting element after the substrate is removed. The non-planar shape of the light emitting element 802 will enhance the light extraction efficiency for light exiting the lower layer of the light emitting element by reducing the likelihood of total internal reflection at the outer surface of the lower layer.

One of skill in the art will recognize that the particular shapes of the layers that are illustrated in these figures are merely presented for illustrative purposes, and other shapes may be formed as technology permits. One of skill in the art will also recognize that a combination of cross-section shaping and perimeter shaping may be used to increase the amount of light that directly escapes the surfaces of the light emitting elements including the creation of facets on the concave or convex surfaces of the substrates.

While the invention has been illustrated and described in detail in the drawings and foregoing description, such illustration and description are to be considered illustrative or exemplary and not restrictive; the invention is not limited to the disclosed embodiments. Variations to the disclosed embodiments can be understood and effected by those skilled in the art in practising the claimed invention, from a study of the drawings and the disclosure. In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage. The scope of the invention is defined by the appended claims.

**Claims**

1. A light emitting device comprising a substrate and a light emitting element on the substrate, the light emitting element comprising:

    an N-type semiconductor player; a P-type semiconductor layer; and an active layer that is situated between the N-type semiconductor layer and the P-type semiconductor layer, wherein the light emitting element includes a side-view profile that includes a polygon with more than four sides, forming a light extraction region that includes a plurality of planar light extraction surfaces, at least one light extraction surface being non-orthogonal to, and non-planar with, an adjacent light extraction surface,
    **characterized in that**,
    the polygon is a regular polygon.

2. The light emitting device of claim 1, wherein the light emitting element further comprises a top-view profile that includes another polygon with more than four sides.

3. The light emitting device of claim 1, wherein the substrate includes a rectangular surface upon which the N-type semiconductor layer, the P-type semiconductor layer, and the active layer are situated.

4. The light emitting device of claim 1, wherein the light emitting element is a polyhedron of at least seven faces.

5. The light emitting device of claim 1, wherein the light emitting element further comprises one or more reflective surfaces.

6. The light emitting device of claim 1, wherein the light emitting element has a shape that corresponds to a combination of multiple polygons or polyhedrons.

7. The light emitting device of claim 1, wherein the substrate includes features that cause the side-view profile of the light emitting element to include the polygon with more than four sides.

8. The light emitting device of claim 7, wherein the light emitting element further comprises a top-view profile that includes another polygon with more than four sides.

9. A method of manufacturing the light emitting device according to any one of claims 1 to 8, comprising:

    forming a plurality of light emitting elements on a substrate, wherein each light emitting element includes a side-view profile that includes a polygon with more than four sides, having a light extraction region that includes a plurality of planar light extraction surfaces, at least one light extraction surface being non-orthogonal to, and non-planar with, an adjacent light extraction surface; and slicing the substrate using a plurality of straight line cuts to singulate the light emitting elements into light emitting devices each having a plurality of planar light extraction surfaces,
    **characterized in that**,
    the polygon is a regular polygon.

10. The method of claim 9, wherein each light emitting element is a polyhedron of at least seven faces.

11. The method of claim 9, wherein at least one surface of each light emitting element is reflective.

12. The method of claim 9, wherein the slicing is performed in two orthogonal directions to provide the singulated light emitting elements on a portion of the substrate that is rectangular.

13. The method of claim 9, wherein the slicing is performed in at least two non-orthogonal directions to provide the singulated light emitting elements on a portion of the substrate that is not rectangular.

**Patentansprüche**

1. Lichtemittierende Vorrichtung, ein Substrat und ein lichtemittierendes Element auf dem Substrat umfassend, wobei das lichtemittierende Element folgendes umfasst:

    eine n-leitende Halbleiterschicht,
    eine p-leitende Halbleiterschicht und
    eine aktive Schicht, die sich zwischen der n-leitenden Halbleiterschicht und der p-leitenden Halbleiterschicht befindet,
    wobei das lichtemittierende Element ein Seitenansichtsprofil umfasst, das ein Polygon mit mehr als vier Seiten beinhaltet, das eine Lichtauskopplungsregion bildet, die mehrere planare Lichtauskopplungsflächen beinhaltet, wobei mindestens eine Lichtauskopplungsfläche nicht rechtwinklig zu und nicht planar mit einer benachbarten Lichtauskopplungsfläche ist,
    **dadurch gekennzeichnet, dass**
    das Polygon ein regelmäßiges Polygon ist.

2. Lichtemittierende Vorrichtung nach Anspruch 1, wobei das lichtemittierende Element ferner ein Draufsichtprofil umfasst, das ein anderes Polygon mit mehr als vier Seiten beinhaltet.

3. Lichtemittierende Vorrichtung nach Anspruch 1, wobei das Substrat eine rechteckige Fläche beinhaltet, auf der sich die n-leitende Halbleiterschicht, die p-leitende Halbleiterschicht und die aktive Schicht befinden.

4. Lichtemittierende Vorrichtung nach Anspruch 1, wobei das lichtemittierende Element ein Polyeder mit mindestens sieben Flächen ist.

5. Lichtemittierende Vorrichtung nach Anspruch 1, wobei das lichtemittierende Element ferner eine oder mehrere reflektierende Flächen umfasst.

6. Lichtemittierende Vorrichtung nach Anspruch 1, wobei das lichtemittierende Element eine Form aufweist, die einer Kombination aus mehreren Polygonen oder Polyedern entspricht.

7. Lichtemittierende Vorrichtung nach Anspruch 1, wobei das Substrat ferner Merkmale beinhaltet, die bewirken, dass das Seitenansichtsprofil des lichtemittierenden Elements das Polygon mit mehr als vier Seiten beinhaltet.

8. Lichtemittierende Vorrichtung nach Anspruch 7, wobei das lichtemittierende Element ferner ein Draufsichtprofil umfasst, das ein anderes Polygon mit mehr als vier Seiten beinhaltet.

9. Verfahren zur Herstellung der lichtemittierenden Vorrichtung nach einem der Ansprüche 1 bis 8, Folgendes umfassend:

    Bilden mehrerer lichtemittierender Elemente auf einem Substrat, wobei jedes lichtemittierende Element ein Seitenansichtsprofil umfasst, das ein Polygon mit mehr als vier Seiten beinhaltet, das eine Lichtauskopplungsregion aufweist, die mehrere planare Lichtauskopplungsflächen beinhaltet, wobei mindestens eine Lichtauskopplungsfläche nicht rechtwinklig zu und nicht planar mit einer benachbarten Lichtauskopplungsfläche ist, und Schneiden des Substrats mit Hilfe mehrerer gerader Schnitte, um die lichtemittierenden Elemente zu lichtemittierenden Vorrichtungen zu vereinzeln, die jeweils mehrere planare Lichtauskopplungsflächen aufweisen,
    **dadurch gekennzeichnet, dass**
    das Polygon ein regelmäßiges Polygon ist.

10. Verfahren nach Anspruch 9, wobei jedes lichtemittierende Element ein Polyeder mit mindestens sieben Flächen ist.

11. Verfahren nach Anspruch 9, wobei mindestens eine Fläche jedes lichtemittierenden Elements reflektierend ist.

12. Verfahren nach Anspruch 9, wobei das Schneiden in zwei rechtwinkligen Richtungen ausgeführt wird, um die vereinzelten lichtemittierenden Elemente auf einem Abschnitt des Substrats bereitzustellen, der rechteckig ist.

13. Verfahren nach Anspruch 9, wobei das Schneiden in mindestens zwei nicht rechtwinkligen Richtungen ausgeführt wird, um die vereinzelten lichtemittierenden Elemente auf einem Abschnitt des Substrats bereitzustellen, der nicht rechteckig ist.

## Revendications

1. Dispositif electroluminescent comprenant un substrat et un élément electroluminescent sur le substrat, l'élément electroluminescent comprenant :

   une couche semi-conductrice de type N ;
   une couche semi-conductrice de type P ; et
   une couche active qui est située entre la couche semi-conductrice de type N et la couche semi-conductrice de type P,
   dans lequel l'élément electroluminescent inclut un profil vu de côté qui inclut un polygone avec plus de quatre côtés, formant une région d'extraction de lumière qui inclut une pluralité de surfaces d'extraction de lumière planes, au moins une surface d'extraction de lumière étant non orthogonale à, et non plane avec, une surface d'extraction de lumière adjacente,
   **caractérisé en ce que**,
   le polygone est un polygone régulier.

2. Dispositif electroluminescent selon la revendication 1, dans lequel l'élément electroluminescent comprend en outre un profil vu de dessus qui inclut un autre polygone avec plus de quatre côtés.

3. Dispositif electroluminescent selon la revendication 1, dans lequel le substrat inclut une surface rectangulaire sur laquelle sont situées la couche semi-conductrice de type N, la couche semi-conductrice de type P et la couche active.

4. Dispositif electroluminescent selon la revendication 1, dans lequel l'élément electroluminescent est un polyèdre d'au moins sept faces.

5. Dispositif electroluminescent selon la revendication 1, dans lequel l'élément electroluminescent comprend en outre une ou plusieurs surfaces réfléchissantes.

6. Dispositif electroluminescent selon la revendication 1, dans lequel l'élément electroluminescent a une forme qui correspond à une combinaison de multiples polygones ou polyèdres.

7. Dispositif electroluminescent selon la revendication 1, dans lequel le substrat inclut des caractéristiques qui amènent le profil vu de côté de l'élément electroluminescent à inclure le polygone à plus de quatre côtés.

8. Dispositif electroluminescent selon la revendication 7, dans lequel l'élément electroluminescent comprend en outre un profil vu de dessus qui inclut un autre polygone à plus de quatre côtés.

9. Procédé de fabrication du dispositif electroluminescent selon l'une quelconque des revendications 1 à 8, comprenant :

   la formation d'une pluralité d'éléments electroluminescents sur un substrat, dans lequel chaque élément electroluminescent inclut un profil vu de côté qui inclut un polygone à plus de quatre côtés, ayant une région d'extraction de lumière qui inclut une pluralité de surfaces d'extraction de lumière planes, au moins une surface d'extraction de lumière étant non orthogonale à, et non plane avec une surface d'extraction de lumière adjacente ; et
   le découpage du substrat en utilisant une pluralité de coupes rectilignes pour séparer les éléments electroluminescents en dispositifs electroluminescents ayant chacun une pluralité de surfaces d'extraction de lumière planes,
   **caractérisé en ce que**
   le polygone est un polygone régulier.

10. Procédé selon la revendication 9, dans lequel chaque élément electroluminescent est un polyèdre d'au moins sept faces.

11. Procédé selon la revendication 9, dans lequel au moins une surface de chaque élément electroluminescent est

réfléchissante.

12. Procédé selon la revendication 9,
dans lequel le découpage est réalisé dans deux directions orthogonales pour obtenir les éléments électroluminescents séparés sur une partie du substrat qui est rectangulaire.

13. Procédé selon la revendication 9,
dans lequel le découpage est réalisé dans au moins deux directions non orthogonales pour obtenir les éléments électroluminescents séparés sur une partie du substrat qui n'est pas rectangulaire.

FIG. 1A

FIG. 1B

FIG. 2A

FIG. 2B

F I G .    3 A    F I G .    3 B

402b 410b 400

410a
402a
420
402f
410f
410e 402e

410c
402c
402d
410d

**F I G . 4 A**

400 411b

411a
411f
411e

411c
421
411d

**F I G . 4 B**

500

510b 502b
510a
502a
510h
502h
520
510g
502g
510f

510c
502c
510d
502d
510e
502e
502f

**FIG. 5A**

500
511a
511h
511g
511f

511b
511c
521
511d
511e

**FIG. 5B**

610

612

614
650

616
650

**F I G . 6 A**  **F I G . 6 B**  **F I G . 6 C**  **F I G . 6 D**

FIG. 7A

FIG. 7B

FIG. 7C

FIG. 7D

FIG. 7E

FIG. 8A

FIG. 8B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004266043 A1
- US 2009032799 A1
- US 2010308300 A1